Europäisches Patentamt

European Patent Office

Office européen des brevets

(11) Publication number: **0 178 129**
**B1**

(12) **EUROPEAN PATENT SPECIFICATION**

(45) Date of publication of patent specification: **06.09.89**

(21) Application number: **85307089.4**

(22) Date of filing: **03.10.85**

(51) Int. Cl.⁴: **H 01 J 37/304**

(54) Apparatus for and method of regulating the shape of a focused ion beam.

(30) Priority: **09.10.84 JP 211675/84**

(43) Date of publication of application:
**16.04.86 Bulletin 86/16**

(45) Publication of the grant of the patent:
**06.09.89 Bulletin 89/36**

(84) Designated Contracting States:
**DE FR GB NL**

(56) References cited:
**EP-A-0 100 634**

**PATENT ABSTRACTS OF JAPAN, vol. 6, no. 238
(E-144)1116r, 26th November 1982; & JP-A-57
139 924 (HITACHI SEISAKUSHO K.K.) 30-08-
1982**

(73) Proprietor: **SEIKO INSTRUMENTS INC.
31-1, Kameido 6-chome Koto-ku
Tokyo 136 (JP)**

(72) Inventor: **Kyogoku, Hideaki Seiko Instruments
& Electron. Ltd
6-31-1, Kameido Koto-ku
Tokyo (JP)**
Inventor: **Kaito, Takashi Seiko Instruments &
Electronics Ltd
6-31-1, Kameido Koto-ku
Tokyo (JP)**

(74) Representative: **Caro, William Egerton et al
J. MILLER & CO. Lincoln House 296-302 High
Holborn
London WC1V 7JH (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

## Description

This invention relates to apparatus for and methods of regulating the shape of focussed ion beams, for example, for use in repairing defects in masks.

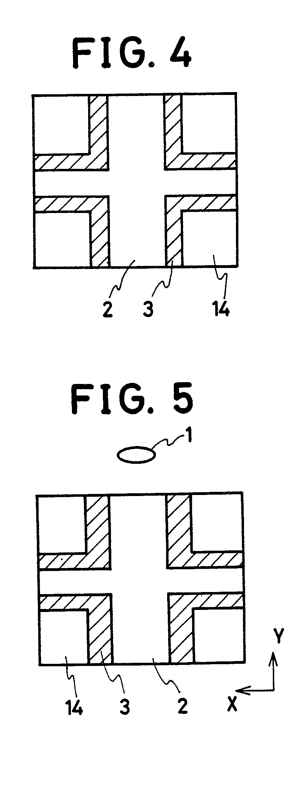

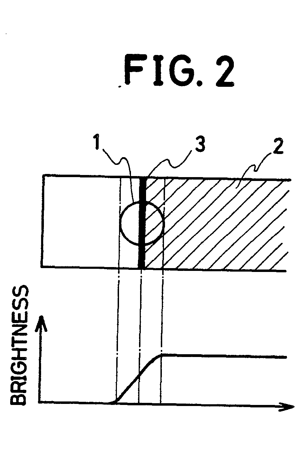

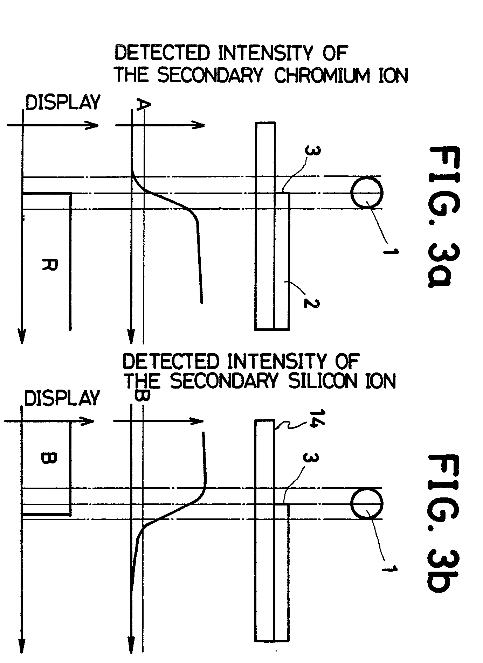

A conventional method of focussing and astigmatically correcting an ion beam is as follows. The intensity of secondary ions which are generated in the surface of a pattern when a sample is scanned with a focused ion beam is detected by a detector. A signal representative of the detected intensity is introduced as a picture signal into a picture display unit so as to observe an image of the pattern. As shown in Figure 2 since the shape of a spot 1 of the ion beam on the surface of the sample has a predetermined area an end region 3 of the image obtained of a pattern 2 on the sample is ill-defined and the brightness of the end region 3 varies with variation in the diameter of the spot 1. The diameter of the spot 1 is regulated as this region of varying brightness of the image is observed with the naked eye. The spot thus cannot be accurately regulated, and regulation requires great skill.

According to one aspect of the present invention there is provided an apparatus for regulating the shape of a focused ion beam, comprising: means for irradiating a mask, which consists of a substrate and a pattern formed thereon, with an ion beam from an ion source; and means for scanning said mask with said ion beam in XY directions, characterised by means for separating a first type of secondary ions, which occur in the surface of said substrate due to said ion beam, and a second type of secondary ions which occur in the surface of said pattern due to said ion beam; means for detecting the intensity of each of the said two types of secondary ions; means for comparing detected signals, which represent said intensities, with a predetermined value; display means for displaying an image of said substrate and an image of said pattern, the images being visually distinct, and an object lens for focussing said ion beam.

Preferably an astigmatic correction electrode is provided for correcting the spot shape of said ion beam.

The display means may be arranged to display each image in a different colour. Alternatively, the display means may be arranged to display each image at a different intensity.

According to another aspect of the present invention there is provided a method of regulating the shape of a focused ion beam comprising the steps of: irradiating a mask, which consists of a substrate and a pattern formed thereon, with an ion beam from an ion source; and scanning said mask with said ion beam in XY directions characterised by separating a first type of secondary ions which occur in the surface of said substrate due to said ion beam and a second type of secondary ions which occur in the surface of said pattern due to said ion beam; detecting the intensity of said two types of secondary ion; comparing detected signals, which represent said intensities, with a predetermined value; displaying an image of said substrate and of said pattern, the images being visually distinct; and employing an object lens to focus said ion beam.

The invention is illustrated, merely by way of example, in the accompanying drawings, in which;-

Figure 1 is a block diagram of an apparatus according to the present invention for regulating the shape of a focused ion beam;

Figure 2 illustrates a conventional method of regulating the shape of a focused ion beam; and

Figures 3a, 3b, 4 and 5 are diagrams used to illustrate the apparatus of Figure 1 and a method according to the present invention of regulating the shape of a focused ion beam.

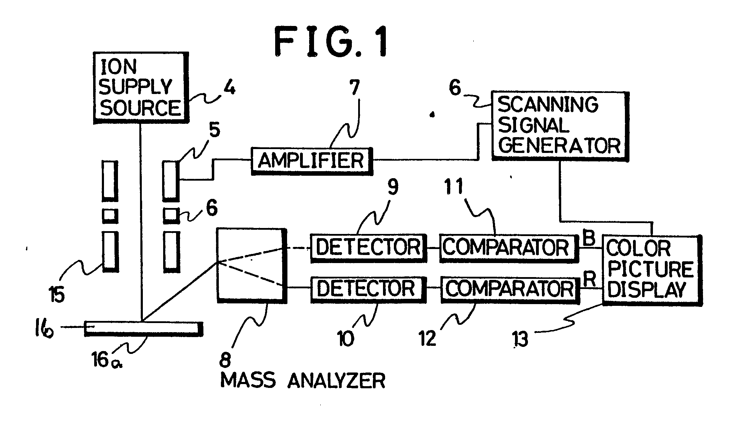

Figure 1 illustrates an apparatus according to the present invention for regulating the shape of a focused ion beam particularly for repairing defects in a mask with an ion beam. To carry out a mask defect repairing operation, it is necessary first to detect the defects. To detect defects in a mask 16, an ion beam is generated from an ion supply source 4, and the surface of the mask 16 is scanned with the ion beam as a deflector 5 is driven to move the ion beam in the XY directions. During this time, the deflector 5 is driven by signals from a scanning signal generator 6 through an amplifier 7.

The ion beam applied to the mask surface causes secondary ions to be discharged therefrom. The secondary ions thus discharged from the surface of the mask are of two types since the substrate and a pattern which constitute the mask 16 are of different materials. For example, silicon ions may be discharged from the surface of the substrate and chromium ions from the surface of the pattern.

These two types of secondary ions are separated by a mass analyzer 8 and are detected by detectors 9,10. Thus electric signals, the levels of which correspond to the intensities of the two types of secondary ions, are obtained. These electric signals are then introduced into respective comparators ll,12, and a logic "1" signal is produced when the level of the electric signal is higher than a predetermined value, and a logic "0" signal when the level is less than the predetermined value.

The binary logic signals thus obtained are introduced into a blue terminal B and a red terminal R of a colour picture display device 13. Consequently, the surface of the substrate is displayed, for example, in a uniform blue, and the surface of the pattern in a uniform red.

At an end region of the pattern, these two colours can not be distinguished from each other. Thus a region of a certain width is displayed in purple which is chromatically between blue and red. The reason why this phenomenon occurs will now be explained.

Referring to Figure 3a an ion beam spot 1 has a predetermined area. When the ion beam is applied to the surface of the mask the detected intensity of secondary chromium ions discharged from the surface of a pattern 2 varies continuously in the vicinity of an end region 3 thereof as shown in Figure 3a. To obtain a binary logic signal corresponding to the intensity of the secondary chromium ions, a threshold electric potential at the comparators is then set as shown by a line A in Figure 3a. As a result, a region which is on the right-hand side of the intersection of the line A and a curve of detected intensity of the secondary chromium ions is displayed pictorially in red.

Referring to Figure 3b, when the ion beam 1 is applied to the surface of the mask, the intensity detected of the secondary silicon ions discharged from the surface of a substrate 14 there is continuously in the vicinity of the end region 3 of the pattern. To obtain a binary logic signal corresponding to the intensity of the secondary silicon ions, a threshold electric potential at the comparators is then set as shown by a line B in Figure 3b. As a result, a region which is on the left-hand side of the intersection of the line B and a curve of detected intensity of the secondary silicon ions is displayed pictorially in blue.

Consequently, as will be appreciated from the results of comparison between Figure 3a and Figure 3b, the red and blue images overlap each other in the portion of the pattern which is in the vicinity of the end portion 3 thereof, and the overlapping portion having a predetermined width is displayed as purple. The width of this overlapping portion is proportional to the diameter of the ion beam spot 1.

Figure 4 shows a specific image. The portion of the pattern 2 is displayed in red, and the portion of the surface of the substrate 14 is displayed in blue. The portion of the pattern end 3 and the neighbouring portion are displayed in purple.

The width of the purple region can be seen clearly with the naked eye. The focal length of an object lens 15 in Figure 1 may be regulated as the width of the purple region is observed. Since the diameter of the ion beam spot is proportional to the width of the purple image, a suitable diameter of ion beam spot can be obtained by reference to the width of the purple image.

When the ion beam spot is elongated in the X-direction as shown in Figure 5, the width of the region of the purple image in the X-direction is larger than that of the region of the purple image in the Y-direction. To correct such an astigmatic spot, an astigmatic correction electrode 16a, shown in Figure 1, may be controlled as the display is observed, in such a manner that the width of the region of the purple image in the X-direction and the width of the region of the purple image in the Y-direction become equal.

It is evident that the present invention can also be applied to the case where the surface of the substrate and the surface of the pattern are displayed at different levels of brightness or intensity rather than in different colours.

It will be appreciated that with the apparatus according to the present invention and described above an ion beam can be focused and astigmatically corrected accurately, quickly and easily as the region of a displayed image of a mask which has a predetermined colour or brightness is observed.

## Claims

1. An apparatus for regulating the shape of a focused ion beam, comprising: means for irradiating a mask (16), which consists of a substrate (14) and a pattern (3) formed thereon, with an ion beam from an ion source (4); and means (5, 6, 7) for scanning said mask with said ion beam in XY directions, characterised by means (8) for separating a first type of secondary ions, which occur in the surface of said substrate due to said ion beam, and a second type of secondary ions which occur in the surface of said pattern due to said ion beam; means (9, 10) for detecting the intensity of each of the said two types of secondary ions; means (11, 12) for comparing detected signals, which represent said intensities, with a predetermined value; display means (13) for displaying an image of said substrate and an image of said pattern, the images being visually distinct; and an object lens (15) for focussing said ion beam.

2. An apparatus as claimed in claim 1 characterised in that an astigmatic correction electrode (16a) is provided for correcting the spot shape of said ion beam.

3. An apparatus as claimed in claim 1 or 2 characterised in that the display means (13) is arranged to display each image in a different colour.

4. An apparatus as claimed in claim 1 or 2 characterised in that the display means (13) is arranged to display each image at a different intensity.

5. A method of regulating the shape of a focused ion beam comprising the steps of: irradiating a mask (16), which consists of a substrate (14) and a pattern (3) formed thereon, with an ion beam from an ion source (4); and scanning said mask with said ion beam in XY directions characterised by separating a first type of secondary ions which occur in the surface of said substrate due to said ion beam and a second type of secondary ions which occur in the surface of said pattern due to said ion beam; detecting the intensity of said two types of secondary ion; comparing detected signals, which represent said intensities, with a predetermined value; displaying an image of said substrate and of said pattern, the images being visually distinct; and employing an object lens (15) to focus said ion beam.

6. A method as claimed in claim 5 characterised in that the spot shape of said ion beam is corrected by means of an astigmatic correction electrode (16a).

7. A method as claimed in claim 5 or 6 characterised by displaying each image in a different colour.

8. A method as claimed in claim 5 or 6 characterised by displaying each image at a different intensity.

**Patentansprüche**

1. Vorrichtung zur Regulierung der Form eines fokussierten Ionenstrahls, umfassend: eine Einrichtung zum Bestrahlen einer Maske (16), die aus einem Substrat (14) und einem darauf gebildeten Muster (3) besteht, mit einem Ionenstrahl aus einer Ionenquelle (4); und eine Einrichtung (5, 6, 7) zum Abtasten der Maske mit dem Ionenstrahl in XY-Richtungen, gekennzeichnet durch eine Einrichtung (8) zum Trennen eines ersten Typs von Sekundärionen, die aufgrund des Ionenstrahls in der Oberfläche des Substrats auftreten, und eines zweiten Typs von Sekundärionen, die aufgrund des Ionenstrahls auf der Oberfläche des Musters auftreten; eine Einrichtung (9, 10) zum Erfassen der Intensität jedes der beiden Typen von Sekundärionen; eine Einrichtung (11, 12) zum Vergleichen erfaßter Signale, die die Intensitäten darstellen, mit einem vorbestimmten Wert; eine Anzeigeeinrichtung (13) zum Anzeigen einer Abbildung des Substrats und einer Abbildung des Musters, wobei die Abbildungen sichtbar verschieden sind; und eine Objektlinse (15) zum, Fokussieren des Ionenstrahls.

2. Vorrichtung nach Anspruch 1, dadurch gekennzeichnet, daß eine astigmatische Korrekturelektrode (16a) vorgesehen ist, um die Fleckform des Ionenstrahls zu korrigieren.

3. Vorrichtung nach Anspruch 1 oder 2, dadurch gekennzeichnet, daß die Anzeigeeinrichtung (13) angeordnet ist, um jede Abbildung in einer verschiedenen Farbe anzuzeigen.

4. Vorrichtung nach Anspruch 1 oder 2, dadurch gekennzeichnet, daß die Anzeigeeinrichtung (13) angeordnet ist, um jede Abbildung mit einer verschiedenen Intensität anzuzeigen.

5. Verfahren zur Regulierung der Form eines fokussierten Ionenstrahls, umfassend die Schritte, daß: eine Maske (16), die aus einem Substrat (14) und einem darauf gebildeten Muster (3) besteht, mit einem Ionenstrahl aus einer Ionenquelle (4) bestrahlt wird; und die Maske mit dem Ionenstrahl in XY-Richtungen abgetastet wird, gekennzeichnet durch Trennen eines ersten Typs von Sekundärionen, die aufgrund des Ionenstrahls in der Oberfläche des Substrat auftreten, und eines zweiten Typs von Sekundärionen, die aufgrund des Ionenstrahls in der Oberfläche des Musters auftreten; Erfassen der Intensität der beiden Sekundärionentypen; Vergleichen erfaßter Signale, die die Intensitäten darstellen, mit einem vorbestimmten Wert; Anzeigen einer Abbildung des Substrats und des Musters, wobei die Abbildungen sichtbar verschieden sind; und Verwenden einer Objektlinse (15) zum Fokussieren des Ionenstrahls.

6. Verfahren nach Anspruch 5, dadurch gekennzeichnet, daß die Fleckform des Ionen-

strahls mit tels einer astigmatischen Korrekturelektrode (16a) korrigiert wird.

7. Verfahren nach Anspruch 5 oder 6, gekennzeichnet durch Anzeigen einer jeden Abbildung in einer verschiedenen Farbe.

8. Verfahren nach Anspruch 5 oder 6, gekennzeichnet durch Anzeigen einer jeden Abbildung mit einer verschiedenen Intensität.

**Revendications**

1. Un appareil pour réguler la forme d'un faisceau d'ions focalisé comprenant: des moyens pour irradier avec un faisceau d'ions provenant d'une source d'ions (4), un masque (16) qui consiste en un substrat (14) et en un motif (3) formé sur le substrat; et des moyens (5, 6, 7) pour balayer le masque avec le faisceau d'ions dans des directions XY, caractérisé par des moyens (8) destinés à séparer un premier type d'ions secondaires, qui apparaissent à la surface du substrat sous l'effet du faisceau d'ions, et un second type d'ions secondaires qui apparaissent à la surface du motif sous l'effet du faisceau d'ions; des moyens (9, 10) pour détecter l'intensité de chacun des deux types d'ions secondaires; des moyens (11, 12) pour comparer avec une valeur prédéterminée des signaux détectés qui représentent les intensités précitées; des moyens de visualisation (13) pour visualiser une image du substrat et une image du motif, ces images étant visuellement distinctes; et un objectif (15) pour focaliser le faisceau d'ions.

2. Un appareil selon la revendication 1, caractérisé en ce qu'il comprend une électrode de correction d'astigmatisme (16a) pour corriger la forme de la trace du faisceau d'ions.

3. Un appareil selon la revendication 1 ou 2, caractérisé en ce que les moyens de visualisation (13) sont conçus de façon à visualiser chaque image avec un couleur différente.

4. Un procédé selon la revendication 1 ou 2, caractérisé en ce que les moyens de visualisation (13) sont conçus de façon à visualiser chaque image avec un intensité différente.

5. Un procédé de régulation de la forme d'un faisceau d'ions focalisé comprenant les opérations suivantes: on irradie avec un faisceau d'ions provenant d'une source d'ions (4), un masque (16) qui consiste en un substrat (14) et en un motif (3) formé sur le substrat;

et on balaye le masque avec le faisceau d'ions dans des directions XY.

caractérisé en ce qu'on sépare un premier type d'ions secondaires qui apparaissent à la surface du substrat sous l'effet du faisceau d'ions, et un second type d'ions secondaires qui apparaissent à la surface du motif sous l'effet du faisceau d'ions; on détecte l'intensité des deux types d'ions secondaires; on compare avec une valeur prédéterminée des signaux détectés qui représentent les intensités précitées;

on visualise une image du substrat et du motif, ces images étant visuellement distinctes; et on utilise un objectif (15) pour focaliser le faisceau d'ions.

6. Un procédé selon la revendication 5, caractérisé en ce que la forme de la trace du faisceau d'ions est corrigée au moyen d'une électrode de correction d'astigmatisme (16a).

7. Un procédé selon la revendication 5 ou 6, caractérisé en ce qu'on visualise chaque image avec une couleur différente.

8. Un procédé selon la revendication 5 ou 6, caractérisé en ce qu'on visualise chaque image avec une intensité différente.

# FIG. 1

ION SUPPLY SOURCE 4

5

6

15

16

16a

AMPLIFIER 7

MASS ANALYZER 8

SCANNING SIGNAL GENERATOR 6

DETECTOR 9

COMPARATOR 11

DETECTOR 10

COMPARATOR 12

COLOR PICTURE DISPLAY 13

B

R

EP 0 178 129 B1

# FIG. 4

2  3  14

# FIG. 5

1

14  3  2  X  Y

2

# FIG. 2

BRIGHTNESS

DETECTED INTENSITY OF
THE SECONDARY CHROMIUM ION

DISPLAY

FIG. 3a

DETECTED INTENSITY OF
THE SECONDARY SILICON ION

DISPLAY

FIG. 3b